# FASCICULE DE BREVET EUROPEEN

(11) **EP 2 526 621 B1**
(45) Date de publication et mention de la délivrance du brevet: **04.10.2017**
(21) Numéro de dépôt: 11706862.7
(22) Date de dépôt: 20.01.2011
(51) Int. Cl.: H03K 17/96, H03K 17/94, G01V 8/12, G06F 3/042

(54) **DISPOSITIF DE COMMANDE ET DISPOSITIF ELECTRONIQUE LE COMPORTANT**
STEUERVORRICHTUNG UND DIESE UMFASSENDE ELEKTRONISCHE VORRICHTUNG
CONTROL DEVICE AND ELECTRONIC DEVICE COMPRISING IT

(30) Priorité: 20.01.2010 FR 1000210
(43) Date de publication de la demande: 28.11.2012
(73) Titulaire: Nexys, 75116 Paris (FR)
(72) Inventeur: PHILIPPE, Sébastien, 30900 Nimes (FR)
(74) Mandataire: Cornuejols, Georges
(86) Numéro de dépôt international: PCT/FR2011/050109
(87) Numéro de publication internationale: WO 2011/089363

(56) Documents cités:
- DE-U1-202005 004 687
- GB-A- 2 161 266
- US-A1- 2009 225 058

## Description

La présente invention concerne un dispositif de commande et un dispositif électronique le comportant. Elle s'applique, en particulier aux interfaces homme-machine, aux interrupteurs, aux potentiomètres et aux variateurs d'intensité électrique ou de tension commandés par le passage à distance du doigt ou de la main de l'utilisateur.

Plus particulièrement, le dispositif de commande objet de la présente invention permet de commander un dispositif électronique ou de faire varier le débit d'une source d'énergie (électricité, eau, gaz, chaleur...) par passage d'un corps mobile (par exemple, une main...) devant ce variateur. La présente invention peut, par exemple, être utilisée sur un lecteur/enregistreur de médias (par exemple, musiques, images fixes ou vidéos), une lampe ou tout autre système d'éclairage (par exemple, dans un gradateur de lumière), un volet roulant automatisé (par exemple pour contact de motorisation), un robinet d'eau ou à gaz (réglage de débit d'eau), un radiateur ou autre équipement de chauffage (par exemple un thermostat), un système de ventilation (par exemple : climatisation, ventilateur), ou encore la sélection d'étage dans un ascenseur, une télécommande ou un clavier.

Il est connu d'utiliser des interrupteurs, variateurs ou gradateurs, potentiomètres linéaires ou rotatifs, ou des boutons, tous à commande manuelle, pour les systèmes d'éclairage ou encore des robinets mécaniques pour les systèmes de contrôle de débit d'eau ou de gaz. Cependant la durée de vie de ces équipements mécaniques est limitée car ils possèdent des pièces mécaniques en mouvement qui se détériorent par usure des parties mécaniques.

On connaît aussi les interfaces tactiles avec lesquels un utilisateur touche un écran tactile pour commander des fonctions. Cependant, la sensibilité de ces écrans est variable et la succession d'appuis provoque une usure.

De plus, l'actionnement manuel des équipements mécaniques ou l'appui sur un écran tactile provoquent une trace disgracieuse et, à la longue, un encrassement. Enfin, les équipements mécaniques et les écrans tactiles présentent des inconvénients en termes d'hygiène et de risque de contamination, surtout en cas d'usage collectif.

On connaît les documents DE 20 2005 004687, GB 2 161 266 et US 2009/225058, qui décrivent respectivement :
- un bouton-contact tactile comportant des pluralités d'émetteurs et de récepteurs de rayonnements électromagnétiques, alternativement disposés le long d'un panneau, une unité de commande et d'évaluation activant un retard de temps entre émetteurs successifs pour que les récepteurs puissent différencier des positions différentes d'un réflecteur situé en regard d'émetteurs,
- un interrupteur comportant une source de radiations et un capteur de radiations en regard d'un écran transparent pour que la présence d'un doigt de l'autre côté de l'acran transparent soit détectée et
- une unité de génération d'image d'un appareil d'affichage, qui génère une image en fonction d'images de réception de lumière, et détecte la présence et de l'image d'un objet dans l'une des images de réception.

La présente invention vise à remédier à ces inconvénients.

A cet effet, la présente invention vise, en premier lieu, un dispositif de commande, comportant au moins un couple émetteur-récepteur, formé d'un émetteur de rayonnements et d'un récepteur de rayonnement émis par ledit émetteur et réfléchi par un corps mobile placé à distance du couple, dans le champ d'émission dudit émetteur, ledit récepteur étant disjoint dudit émetteur et adapté à fournir un signal électrique représentatif du rayonnement de l'émetteur qu'il reçoit, caractérisé en ce qu'il comporte, en outre :
- un moyen d'affichage adapté, pour au moins un dit couple, à afficher au moins un symbole identifiant une action, face à une intersection du cône d'émission dudit émetteur et du cône de réception dudit récepteur, ledit émetteur et ledit récepteur étant ainsi en dehors de la zone d'affichage de chaque symbole et
- un moyen de commande adapté à fournir des signaux de commande d'action en fonction du signal électrique fournis par au moins un dit récepteur, chaque couple d'émetteur-récepteur étant ainsi associé à au moins un symbole et au moins une action commandée lorsque le corps mobile se trouve devant le symbole identifiant ladite action.

Grâce à ces dispositions, pour faire commander une action, par exemple une lecture de média, une pause dans la lecture, une avance ou un retour rapides, un arrêt, l'utilisateur n'a qu'à pointer son doigt vers le symbole identifiant cette action, sans avoir à toucher le dispositif de commande.

Du fait que le dispositif de commande objet de la présente invention est sans contact, son ergonomie peut être améliorée par rapport aux dispositifs de l'art antérieur. Cette ergonomie peut aussi être, dans des variantes, adaptative, c'est-à-dire paramétrable par l'installateur, par l'utilisateur ou par un logiciel, par exemple en fonction des actions disponibles dans un état donné du dispositif. Par exemple, la portée, la durée nécessaire au déclenchement d'une action et les mouvements déclenchant une action peuvent être réglés à l'installation ou après l'installation, à la demande de l'utilisateur ou par logiciel.

Du fait qu'il n'y a pas de pièce mécanique actionnée par l'utilisateur, la fiabilité et la durée de vie du dispositif de commande peuvent être supérieures à celles des dispositifs de l'art antérieur.

Le dispositif de commande objet de la présente évite aussi les manipulations, notamment dans les milieux suivants :
- humide : salle de bain, extérieurs, immersion, où il y a des risques d'électrocution,
- salissant : industrie, lieux publics (transports, ascenseur), et
- propres : hôpitaux, industries agroalimentaires, lieux publics.

La mise en oeuvre du dispositif de commande objet de la présente invention réduit aussi les risques de vandalisme, le dispositif de commande pouvant être blindé ou caché, et les risques d'encrassement ou de contamination.

Selon des caractéristiques particulières, le moyen d'affichage est adapté à afficher au moins un symbole par émission de lumière. Grâce à ces dispositions, le symbole affiché est plus visible, notamment en conditions de faible luminosité ambiante.

Selon des caractéristiques particulières, le moyen d'affichage est adapté à afficher au moins un symbole sur un écran. Grâce à ces dispositions, différents symboles ou différentes couleurs ou contrastes d'un même symbole peuvent être affichés par le même moyen d'affichage.

On note que le moyen d'affichage peut aussi afficher au moins un symbole imprimé, sérigraphié, gravé ou teinté dans la masse.

Selon des caractéristiques particulières, la zone d'affichage d'au moins un symbole est entourée d'au moins trois émetteurs et/ou récepteurs, les segments de droites reliant chaque émetteur à chaque récepteur chevauchant une zone d'affichage d'un symbole.

La présente invention permet ainsi de constituer un écran tactile qui fonctionne sans contact entre le doigt de l'utilisateur et l'écran, ce qui présente les avantages indiqués en préambule, par rapport aux écrans tactiles traditionnels. On note qu'en utilisant des sources de lumière pulsées et des moyen de reconnaissance des pulsations émises, on peut constituer un écran tactile matriciel capable de discriminer un nombre de zones tactiles égal au produit du nombre d'émetteurs par le nombre de récepteurs, ces émetteurs et récepteurs étant positionnés autour de l'écran.

Selon des caractéristiques particulières, le moyen de commande comporte un moyen de traitement adapté à éliminer l'influence de la lumière ambiante non réfléchie par l'objet mobile réfléchissant.

Grâce à ces dispositions, le dispositif de commande objet de la présente invention peut être utilisé alors même que le rayonnement ambiant est du même ordre de grandeur, voire supérieur, au rayonnement réfléchi par le corps mobile vers le récepteur.

Selon des caractéristiques particulières, au moins un émetteur de rayonnements est adapté à émettre des rayonnements de manière intermittente et le moyen de traitement est adapté à mémoriser un niveau de signal électrique fourni par chaque récepteur lorsque l'émetteur de rayonnement n'émet pas de rayonnement, les signaux de commande d'action étant fonction du rayonnement instantané reçu et du niveau mémorisé.

Selon des caractéristiques particulières, au moins un émetteur de rayonnements est adapté à émettre des rayonnements de manière intermittente et le moyen de traitement est adapté à extrapoler un niveau de signal électrique fourni par chaque récepteur lorsque l'émetteur de rayonnement n'émet pas de rayonnement, les signaux de commande d'action étant fonction du rayonnement instantané reçu et du niveau extrapolé.

Grâce à chacune de ces dispositions, le moyen de traitement peut tenir compte du rayonnement ambiant courant reçu par chaque récepteur et déterminer, pour chaque récepteur, le rayonnement reçu après réflexion sur l'objet mobile réfléchissant, ce qui augmente la précision de détermination de sa présence.

Selon l'invention, au moins un émetteur ou un récepteur de rayonnements est associé à au moins un masque dont la partie transparente, pour au moins une longueur d'onde utilisée par l'émetteur, est allongé dans la direction d'un récepteur capable de détecter la lumière à ladite longueur d'onde.

Grâce à ces dispositions, les signaux parasites sont fortement réduits.

Selon des caractéristiques particulières, le moyen de commande est adapté à fournir un signal de sortie modulé en largeur d'impulsion.

Selon des caractéristiques particulières, le dispositif de commande tel que succinctement exposé ci-dessus comporte un moyen de communication pour recevoir ou transmettre des commandes à distance.

Grâce à ces dispositions, le dispositif de commande peut communiquer avec des actionneurs, des circuits électroniques externes ou des dispositifs de commande homologues.

Selon des caractéristiques particulières, dans au moins un couple émetteur-récepteur, les axes de l'émetteur et du récepteur sont convergents. L'inventeur a, en effet, découvert que cette disposition augmentait la sensibilité du dispositif de commande tout en réduisant l'incidence des parasites et du bruit lumineux ambiant.

Selon des caractéristiques particulières, le moyen d'affichage est adapté, pour au moins un dit couple, à afficher au moins un symbole identifiant une action, un axe perpendiculaire à un plan portant ledit symbole et prenant appui dans la zone convexe définie par ledit symbole intersectant l'axe d'émission dudit émetteur et/ou l'axe de réception dudit récepteur.

Selon des caractéristiques particulières, un doigt placé au contact de la zone d'affichage d'un symbole n'est pas détecté, cet objet ne réfléchissant alors aucun rayonnement émis par un émetteur en direction d'un récepteur de rayonnement. On réduit ainsi le risque que le doigt d'un utilisateur touche la surface du dispositif et puisse l'encrasser.

La présente invention vise, en deuxième lieu, un dispositif électronique adapté à réaliser des actions, caractérisé en ce qu'il comporte un dispositif de commande objet de la présente invention qui commande au moins une dite action.

La présente invention vise, en troisième lieu, un procédé de commande avec un dispositif comportant au moins un couple émetteur-récepteur, formé d'un émetteur de rayonnements et d'un récepteur de rayonnement émis par ledit émetteur et réfléchi par un corps mobile placé à distance du couple, dans le champ d'émission dudit émetteur, ledit récepteur étant disjoint dudit émetteur et adapté à fournir un signal électrique représentatif du rayonnement de l'émetteur qu'il reçoit,
couple dans lequel au moins un dit émetteur ou un dit récepteur de rayonnements est associé à au moins un masque dont la partie transparente, pour au moins une longueur d'onde utilisée par ledit émetteur, est allongée dans la direction d'un dit récepteur ou d'un dit émetteur, respectivement, capable de détecter la lumière à ladite longueur d'onde, caractérisé en ce qu'il comporte, en outre :
- une étape d'affichage, pour au moins un dit couple, d'au moins un symbole identifiant une action, face à une intersection du cône d'émission dudit émetteur et du cône de réception dudit récepteur, ledit émetteur et ledit récepteur étant ainsi en dehors de la zone d'affichage de chaque symbole et
- une étape de commande qui fournit des signaux de commande d'action en fonction du signal électrique fournis par au moins un dit récepteur, chaque couple d'émetteur-récepteur étant ainsi associé à au moins un symbole et au moins une action commandée lorsque le corps mobile se trouve devant le symbole identifiant ladite action.

Les avantages, buts et caractéristiques particulières de ce dispositif électronique et de ce procédé étant similaires à ceux du dispositif de commande objet de la présente invention, tels que succinctement exposés ci-dessus, ils ne sont pas rappelés ici.

D'autres avantages, buts et caractéristiques de la présente invention ressortiront de la description qui va suivre, faite, dans un but explicatif et nullement limitatif, en regard des dessins annexés dans lesquels :
- la figure 1 représente, schématiquement, un premier mode de réalisation du dispositif de commande objet de la présente invention,
- les figures 2A et 2B représentent, schématiquement, en coupe et de face, un deuxième mode de réalisation du dispositif de commande objet de la présente invention,
- la figure 3 représente, en schéma-bloc, les ensembles fonctionnels d'un circuit électronique incorporé dans le mode de réalisation de dispositif de commande illustré en figure 2,
- la figure 4 représente un logigramme d'étapes mises en oeuvre par le dispositif de commande illustré en figures 2 et 3,
- la figure 5 représente, schématiquement, un troisième mode de réalisation du dispositif de commande objet de la présente invention,
- la figure 6 représente, schématiquement, en coupe, un quatrième mode de réalisation du dispositif de commande objet de la présente invention,
- la figure 7 représente, schématiquement, de face, un cinquième mode de réalisation du dispositif de commande objet de la présente invention,
- la figure 8 représente, schématiquement, de face, un sixième mode de réalisation du dispositif de commande objet de la présente invention,
- la figure 9 représente, schématiquement, de face, un septième mode de réalisation du dispositif de commande objet de la présente invention et
- les figures 10 et 11 représentent une variante du quatrième mode de réalisation du dispositif illustré en figure 6, selon deux autres axes perpendiculaires entre eux et avec l'axe de la coupe illustrée en figure 6.

Dans toute la description, on décrit la mise en oeuvre de rayonnements lumineux infrarouges. Cependant, la présente invention ne se limite pas à ce type de rayonnements mais s'étend, au contraire, aux rayonnements sonores, notamment ultrasonores, et aux champs électriques pour déterminer une variation d'inductance.

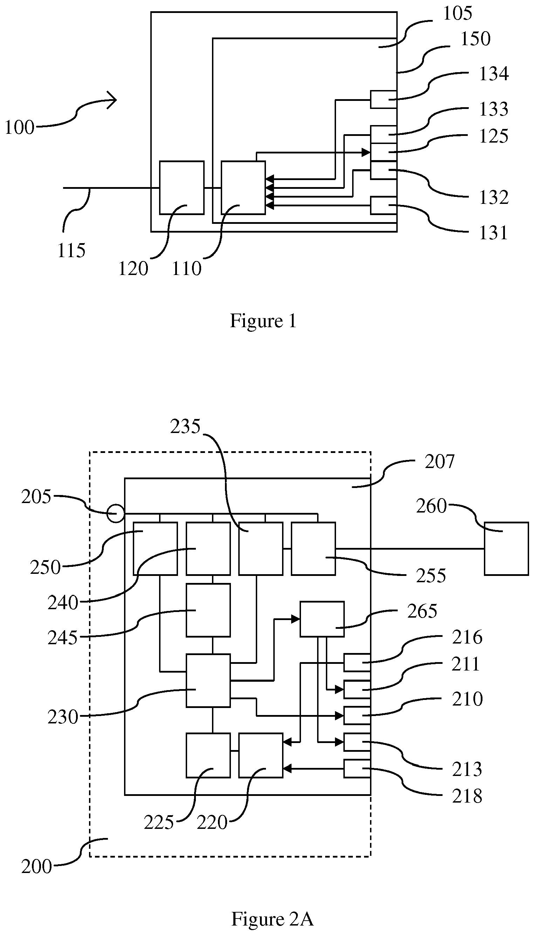

On observe, en figure 1, un dispositif électronique 100 comportant un dispositif de commande 105, un microprocesseur 110, un cordon d'alimentation par le secteur 115, une source d'énergie 120 et un moyen d'affichage 150.

Le dispositif de commande 105 comporte un émetteur infrarouge 125 et quatre récepteurs infrarouges 131 à 134. On constitue ainsi quatre couples émetteur-récepteur (125-131, 125-132, 125-133 et 125-134), formés de l'émetteur de rayonnements 125 et de l'un des récepteurs qui reçoivent le rayonnement émis par l'émetteur et réfléchi par un corps mobile placé à distance du couple, dans le champ d'émission de l'émetteur 125. On note que, dans chaque couple, le récepteur est disjoint de l'émetteur et adapté à fournir un signal électrique représentatif du rayonnement de l'émetteur qu'il reçoit.

La source d'énergie 120 est, par exemple, une pile, un accumulateur, un capteur photovoltaïque ou un transformateur relié au secteur ou un circuit à base de diode Zener reliée au secteur ou un régulateur à découpage.

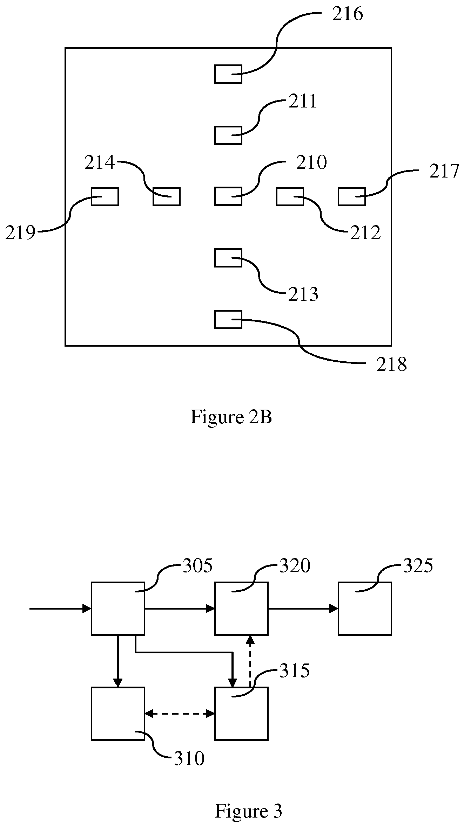

L'émetteur infrarouge 125 et les récepteurs infrarouges 131 à 134 fonctionnent comme expliqué en regard des figures 2A et 2B pour l'émetteur infrarouge 210 et les quatre récepteurs infrarouges 216 à 219, respectivement. Le microprocesseur 110 comporte des entrées logiques qui transforment les niveaux de signal électrique reçus des récepteurs infrarouges 131 à 134 en un niveau de tension logique.

Le niveau de référence est un niveau déterminé à la fabrication ou à l'installation comme représentatif de l'absence d'un objet mobile réfléchissant les infrarouges, à une distance prédéterminée, par exemple un doigt placé à trois centimètres des récepteurs 131 à 134, dans le champ d'émission de l'émetteur 125.

Le moyen d'affichage 150 est adapté, pour chaque couple émetteur-récepteur, à afficher au moins un symbole (211 à 214 en figure 2B) identifiant une action, à mi-distance entre l'émetteur et le récepteur. Par exemple, chaque symbole est constitué par une sérigraphie dans une plaque transparente, par exemple en matière plastique, qui recouvre l'émetteur 125 et les récepteurs 131 à 134. Chaque symbole est, dans un mode de réalisation préférentiel, éclairé par rétro-éclairage, par exemple par une diode électroluminescente (« DEL »). Dans des modes de réalisation, chaque éclairage est commandé, en intensité et/ou en couleur, par le microprocesseur 110.

Le microprocesseur 110 constitue un moyen de commande adapté à fournir des signaux de commande d'action en fonction du signal électrique émis par au moins un dit récepteur. Chaque couple d'émetteur-récepteur est ainsi associé à au moins un symbole affiché par le moyen d'affichage 150 et au moins une action commandée par le microprocesseur lorsque le corps mobile se trouve devant le symbole identifiant ladite action.

On observe qu'en variante, un seul émetteur, un seul symbole, et un seul récepteur, éventuellement combinés en un seul composant émetteur/récepteur/symbole, permet de réaliser un bouton de commande ou un interrupteur à deux positions stables : à chaque passage d'un objet réfléchissant en regard du symbole affiché, le bouton ou l'interrupteur change de position.

On observe, en figures 2A et 2B, intégrés dans un dispositif électronique 200 (partiellement représenté en traits interrompus) et reliés à des câbles d'alimentation secteur 205 (dont la gaine est vue en coupe en figure 2A), un dispositif de commande 207 comportant un émetteur infrarouge 210, quatre récepteurs infrarouges 216 à 219, un multiplexeur 220, un numériseur 225, un contrôleur 230, un module de synchronisation 235, un transformateur 240, un régulateur 245, un modem 250 et un module de puissance 255 relié à une charge électrique 260.

L'émetteur infrarouge 210 est, par exemple, une diode électroluminescente possédant un angle d'émission large, par exemple 120°. Son émission est commandée par le contrôleur 230. Les quatre récepteurs infrarouges 216 à 219 sont des photodiodes, des phototransistors ou des photorésistances de type connu. Ils sont positionnés, dans ce mode de réalisation, sur une ligne verticale (émetteurs 216 et 218) et sur une ligne horizontale (217 et 219), à intervalles réguliers, ces lignes se coupant à la position de l'émetteur infrarouge 210. Leurs sorties sont reliées à l'entrée du multiplexeur 220 qui est commandé par le contrôleur 230 et fournit, tour à tour, au numériseur 225, les signaux sortant des récepteurs infrarouges 216 à 219.

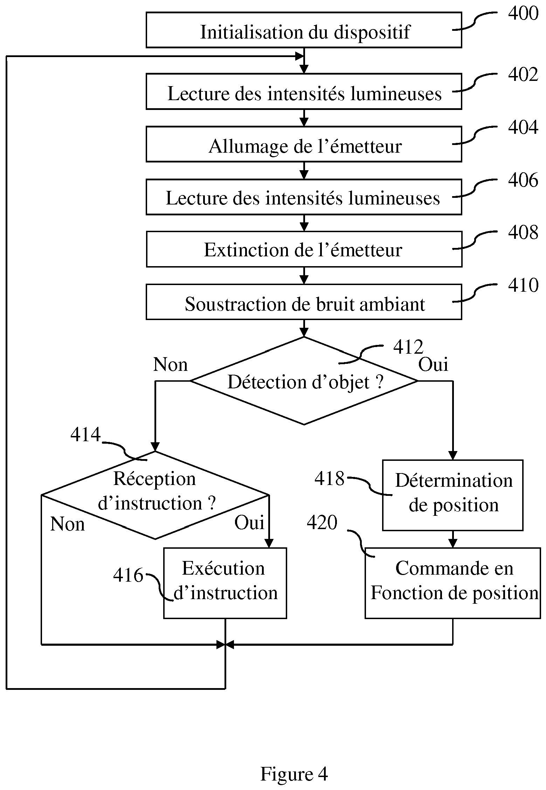

Le numériseur 225 reçoit les signaux sortant du multiplexeur 220 et fournit un signal numérisé au contrôleur 230. Le contrôleur 230, qui comporte une horloge, une mémoire vive et une mémoire morte (non représentés), est de type connu. Il met en oeuvre un programme conservé dans sa mémoire morte pour implémenter le logigramme illustré en figure 4.

Le module de synchronisation 235 fournit au contrôleur 230 un signal indiquant le passage à zéro de la tension secteur, d'une part, et commande la sortie du module de puissance 255.

Le module de puissance 255, qui assure une distribution de l'énergie en fonction d'une commande fournie par le contrôleur 230, est constitué par l'intermédiaire soit d'un circuit gradateur (équipé d'un triac et de sa commande reliée à un signal de sortie en modulation de largeur d'impulsion PWM) soit de transistors, soit de relais, soit de potentiomètres permettant de contrôler le flux d'énergie tout en dissipant la puissance sans occasionner de dégâts sur ces mêmes composants, soit par l'intermédiaire d'un moteur pas-à-pas contrôlant un potentiomètre.

Dans le cas d'un circuit gradateur, il est possible de commander ce dernier par le signal de modulation de largeur d'impulsion PWM du contrôleur 230 et par l'intermédiaire d'un composant de commande de triac (détection du zéro du secteur pour synchronisation) isolant galvaniquement (par moyens optiques, par exemple des optocoupleurs) le circuit de puissance du circuit de commande.

Le transformateur 240 et le régulateur 245 fournissent une tension continue au contrôleur 230 et aux autres composants requérant une alimentation continue. Le transformateur 240 effectue une diminution de la tension alternative et le régulateur 245 effectue une transformation de la tension alternative en tension continue régulée.

Le modem 250 est relié au contrôleur 230 et au secteur et met en oeuvre des signaux en courant porteur pour que le contrôleur 230 communique avec d'autres contrôleurs communiquant par courant porteur. En variante, le modem 250 est relié à un émetteur-récepteur infrarouge ou radio pour communiquer avec d'autres contrôleurs homologues.

Grâce au multiplexeur 220 et au numériseur 225, le contrôleur dispose des valeurs numériques des intensités lumineuses reçues par les récepteurs infrarouges 216 à 219, y compris les intensités lumineuses des rayons émis par l'émetteur infrarouge 210 et réfléchis par les objets se trouvant en regard de cet émetteur et des récepteurs, c'est-à-dire dans leurs champs d'émission ou de réception, respectivement.

Le contrôleur 230 commande l'allumage intermittent de l'émetteur 210, de manière synchronisée avec le multiplexeur 220 pour obtenir successivement les valeurs numériques des intensités lumineuses infrarouge reçues par les récepteurs 216 à 219, lorsque l'émetteur 210 est éteint et ces valeurs numériques lorsque l'émetteur 210 est allumé.

Dans des variantes, on utilise la modulation de largeur d'impulsion (connu sous son acronyme anglais PWM pour "pulse width modulation"), afin de moduler un signal lumineux émis susceptible d'être reconnu parmi les signaux parasites.

Par comparaison des intensités lumineuses reçues lorsque l'émetteur est allumé et lorsque l'émetteur est éteint, le contrôleur 230 élimine l'influence de la lumière ambiante, ou bruit, et détermine la quantité de lumière émise par le récepteur 210 qui est réfléchie vers chaque récepteur 216 à 219.

En variante, pour éliminer l'influence de la lumière ambiante, le contrôleur 230 soustrait des valeurs des intensités lumineuses reçues par les récepteurs 216 à 219, leurs valeurs moyennes sur une longue durée, par exemple cinq secondes ou leur valeur extrapolée avec une fonction d'extrapolation de type connu. En variante, le signal est discriminé soit par un seuil, soit par fréquence permettant de savoir si le récepteur reçoit la modulation en largeur d'impulsion PWM d'un émetteur ou celui d'un autre, soit par les deux.

En variante, pour compenser les différences d'exposition à la lumière émise par l'émetteur 210, le contrôleur 230 applique un coefficient multiplicatif aux valeurs numérisées d'intensités lumineuses reçues par les récepteurs 216 à 219. Ces coefficients sont, par exemple, l'inverse des intensités lumineuses mesurées en remplaçant l'objet mobile par une paroi blanche placée à une distance prédéterminée du dispositif de commande, par exemple 30 cm.

Puis, le contrôleur 230 détermine la position d'un objet réfléchissant situé en regard du dispositif de commande, en fonction des niveaux des intensités lumineuses reçues par les récepteurs 216 à 219. Par exemple, le contrôleur 230 ne détermine que le numéro du récepteur qui reçoit l'intensité lumineuse réfléchie la plus élevée comme position de l'objet réfléchissant. La position de l'objet réfléchissant déterminée par le contrôleur 230 peut alors prendre autant de valeurs qu'il y a de récepteurs.

En variante, on utilise, comme valeur limite, la valeur moyenne de la dernière mesure afin d'éviter une valeur limite obsolète car déterminée au moment démarrage.

En fonction de la position ainsi déterminée, le contrôleur 230 commande le module de puissance en modulation de largeur d'impulsion, en tenant compte du signal de synchronisation fourni par le module de synchronisation 235.

En dehors des phases pendant lesquelles le contrôleur 230 détermine si un objet mobile se trouve en regard du dispositif de commande, le contrôleur 230 prend en compte les consignes qu'il reçoit d'autres dispositifs de commande, par l'intermédiaire du modem 250.

Un moyen d'affichage 265 est adapté, pour chaque couple émetteur-récepteur, à afficher au moins un symbole (211 à 214 en figure 2B) identifiant une action, entre l'émetteur et le récepteur. Par exemple, chaque symbole est constitué par une sérigraphie dans une plaque transparente, par exemple en matière plastique, qui recouvre l'émetteur 125 et les récepteurs 131 à 134. Chaque symbole est, dans un mode de réalisation préférentiel, éclairé par rétro-éclairage, par exemple par une diode électroluminescente (« DEL »). Dans des modes de réalisation, chaque éclairage est commandé, en intensité et/ou en couleur, par le microprocesseur 110 en fonction des actions disponibles à un instant donné.

On observe, en figure 3, les ensembles fonctionnels du dispositif de commande illustré en figures 2A et 2B. Dans cette figure 3, les flèches en traits interrompus représentent les flux d'information et les flèches en trait plein représentent les flux d'énergie. Sont représentés, en figure 3, une alimentation 305, un module optique 310, un module de traitement de données 315, un module de puissance 320 et une charge électrique 325.

Comme indiqué en regard des figures 2A et 2B, l'alimentation 305 comporte, par exemple, une batterie ou un transformateur relié au secteur. Le module optique 310 comporte l'émetteur infrarouge 210 et les récepteurs infrarouges 216 à 219. L'émission de rayons infrarouges par l'émetteur infrarouge 210 est commandée par le module de traitement de données 315 et les signaux issus des récepteurs infrarouges 216 à 219 sont transmis au module de traitement de données 315. Le module de traitement de données 315 détermine si un objet au moins partiellement réfléchissant dans le spectre d'émission et de réception des signaux infrarouges, par exemple une main ou un doigt, se trouve en regard du module optique 310 et, si oui, la position de cet objet mobile. En fonction de ces informations, le module de traitement de données commande la puissance électrique fournie par le module de puissance 320 à la charge électrique 325.

On observe, en figure 4, une étape 400 d'initialisation du dispositif de commande, puis une étape 402 de lecture des intensités lumineuses reçues par les récepteurs infrarouges. Au cours d'une étape 404, on commande l'allumage de l'émetteur de rayons infrarouges. Puis, au cours d'une étape 406, on lit les intensités lumineuses reçues par les récepteurs infrarouges. Au cours d'une étape 408, on éteint l'émetteur de rayons infrarouges afin de laisser cette source refroidir, augmenter sa durée de vie et, éventuellement, de réduire la consommation électrique. Au cours d'une étape 410, on soustrait des valeurs lues au cours de l'étape 406, les valeurs correspondantes lues au cours de l'étape 402.

Au cours d'une étape 412, on détermine si une réflexion sur un objet en regard du dispositif de commande a eu lieu en comparant les résultats des soustractions à une valeur seuil. Si tous les résultats sont inférieurs au seuil, on détermine si une instruction de commande a été reçue de la part d'un autre dispositif de commande, au cours d'une étape 414. Si aucune instruction n'a été reçue, on retourne à l'étape 402. Si une instruction a été reçue, on exécute cette instruction, par exemple en commandant le module de puissance, étape 416, et en maintenant cette commande jusqu'à une autre étape 416 ou une étape 420 et on retourne à l'étape 402.

Si au moins un résultat de soustraction est supérieur à la valeur seuil, au cours d'une étape 418, on détermine la position de l'objet en regard d'un symbole et, au cours d'une étape 420, on commande, en fonction du symbole considéré, ou de la position de l'objet, le module de puissance et on maintient cette commande jusqu'à une autre étape 420 ou une étape 416. Puis on retourne à l'étape 402.

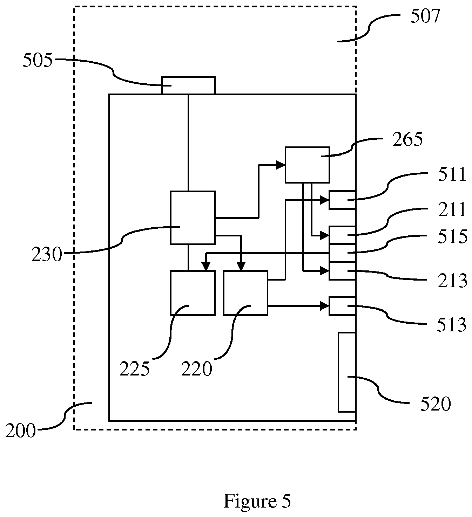

On observe, en figure 5, un dispositif de commande 507 comportant les mêmes éléments que le dispositif de commande 207 illustré en figures 2A et 2B, à l'exception :
- de l'émetteur infrarouge 210 qui est remplacé par quatre émetteurs infrarouges 511 à 514 (seuls les émetteurs 511 et 513 sont vus dans cette vue en coupe),
- des quatre récepteurs infrarouges 216 à 219, qui sont remplacés par un unique récepteur infrarouge 515,
- des câbles d'alimentation secteur 205, qui sont remplacés par un connecteur 505 et
- du module de synchronisation 235, du transformateur 240, du régulateur 245, du modem 250, du module de puissance 255 et de la charge électrique 260, qui sont absents.

Les commandes émis par le dispositif de commande 507 sont véhiculées par le connecteur 505, ainsi que l'alimentation du dispositif de commande 507.

Les émetteurs infrarouges 511 à 514 présentent des angles d'émission juxtaposés. Le récepteur infrarouge 515 présente un angle de réception large, par exemple de 120°. Le fonctionnement du dispositif de commande est le suivant : les émetteurs infrarouges 511 à 514 sont allumés séquentiellement, une phase d'extinction de tous les émetteurs étant prévue entre deux séquences d'allumage successives des différents émetteurs infrarouges.

Le contrôleur 230 détermine l'influence de la lumière ambiante et la position d'un éventuel objet mobile placé en regard de l'un des émetteurs, en fonction des intensités lumineuses successivement reçues par le récepteur 515, d'une manière similaire à celle décrite en regard des figures 2A et 2B.

Dans ce mode de réalisation, un afficheur 520 permet la communication entre le contrôleur 230 et l'utilisateur. Par exemple, le contrôleur 230 affiche sur l'afficheur 520 des messages représentatifs des commandes reçus par courant porteur, des états ou des modes de fonctionnement du dispositif électronique.

On observe que la disposition des récepteurs en étoile illustrée en figure 2A et 2B peut prendre la forme d'une étoile possédant n'importe quel nombre de rayons. Cette disposition en étoile avec un récepteur central peut aussi être remplacée par une disposition en forme polygonale, par exemple carrée ou hexagonale, éventuellement complétée par un récepteur central ou un deuxième polygone incorporé dans le premier.

Dans des variantes, on prévoit que chaque récepteur infrarouge est couplé à un émetteur infrarouge en étant intégré à un composant assurant ces deux fonctions.

Des solutions matérielles et/ou logicielles peuvent être apportées afin d'éviter le déclenchement d'actions non voulues (par exemple, si plusieurs des capteurs sont « excités » en même temps, il n'y a pas d'action commandée).

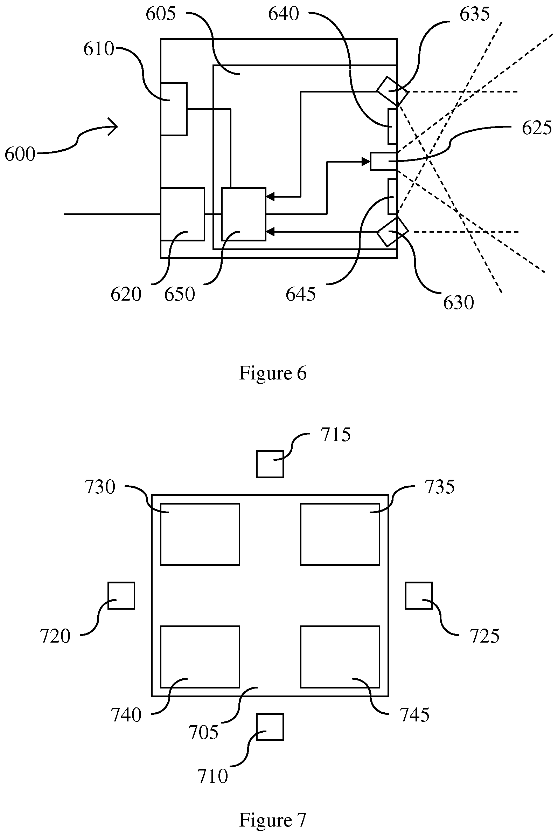

On observe, en figure 6, un dispositif électronique 600 comportant un dispositif de commande 605, un connecteur 610 et une source d'énergie 620.

Le dispositif de commande 605 comporte un émetteur infrarouge 625, deux récepteurs infrarouges 630 et 635 et un afficheur comportant des supports de symboles 640 et 645 et un contrôleur 650. Les symboles portés par les supports de symboles 640 et 645 correspondent aux actions déclenchées, dans le dispositif électronique 600, par le contrôleur 650, par l'intermédiaire du connecteur 610, lorsqu'un doigt de l'utilisateur se trouve en regard de ce symbole. La présence d'un doigt est détectée, par le contrôleur 650, en fonction des signaux émis par les récepteurs infrarouge 630 et 635, comme exposé ci-dessus.

Dans le mode de réalisation illustré en figure 6, les récepteurs 630 et 635 possèdent des axes orientés vers l'émetteur 625. Dans l'exemple illustré en figure 6, les orientations de ces axes sont d'environ 35° par rapport à l'axe de l'émetteur 625. Les champs optiques des récepteurs sont ici d'environ 70°, soit +/- 35° par rapport à leur axe. L'émetteur 625 possède ici un champ optique s'étendant sur environ 150°.

Ces dispositions sont avantageuses pour augmenter la sensibilité du dispositif à une distance correspondant à la convergence des axes des récepteurs sur l'axe de l'émetteur et en dessous de cette distance. En effet, un objet réfléchissant placé entre ce plan et le plan de la face avant du dispositif réfléchira la lumière vers les récepteurs depuis une direction correspondant sensiblement à leur maximum de sensibilité.

L'inventeur a découvert que, toutes choses égales par ailleurs, l'inclinaison respective des éléments d'un couple émetteur-récepteur permettait d'en augmenter la portée et donc le confort d'utilisation de l'utilisateur et la tolérance aux parasites, bruits et sources de lumières externes.

Pour réaliser cette inclinaison respective, l'homme du métier peut prévoir des cales en matériau non conducteur ou, plus simplement, tordre légèrement les pattes des composants concernés, entre ces composants et le circuit électronique sur lequel ils sont montés.

Cet enseignement concernant l'inclinaison respective préférentielle des éléments des couples émetteur-récepteur ne se limite pas au cas où il n'y a que deux tels couples mais s'étend, au contraire à tous les modes de réalisation de la présente invention et, en particulier, aux modes de réalisation particuliers illustrés en regard des figures 1 à 5.

Ainsi, préférentiellement, le dispositif objet de la présente invention est adapté à détecter un objet placé à distance du dispositif et à ne pas détecter un objet au contact du dispositif. Cet objet ne réfléchit alors aucun rayonnement en direction du récepteur de rayonnement. On évite ainsi les traces de doigt et les risques d'encrassement de la surface du dispositif.

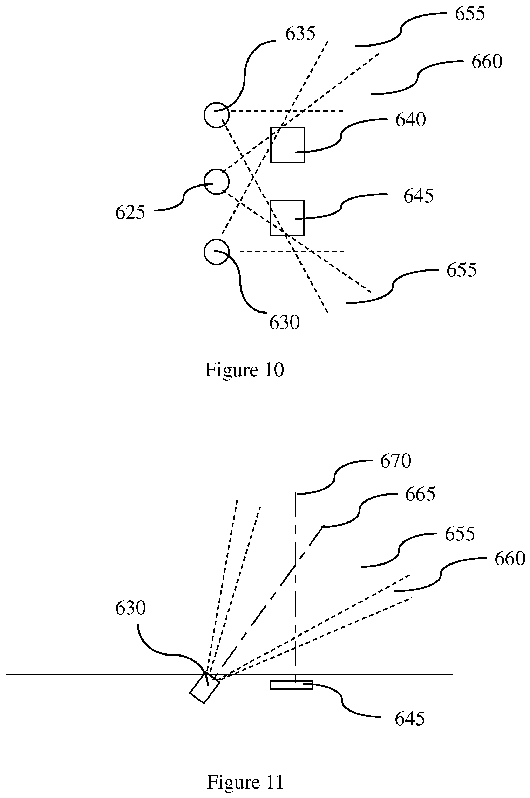

Les figures 10 et 11 représentent une variante du quatrième mode de réalisation du dispositif illustré en figure 6, selon deux autres axes perpendiculaires entre eux et avec l'axe de la coupe illustrée en figure 6. La figure 10 est une vue de face du dispositif qui représente donc sensiblement ce que voit l'utilisateur. La figure 11 est une vue de côté, en coupe.

On observe, en figure 10 que le moyen d'affichage de symboles 640 et 645 est adapté, pour chaque couple 625 et 630, d'une part et 625 et 635, d'autre part, d'émetteur et de récepteur, à afficher les symboles 640 et 645 face à une intersection du cône d'émission 660 de l'émetteur 625 et du cône de réception 655 du récepteur 630 ou 635. L'émetteur et le récepteur sont ainsi encore plus éloignés de la zone d'affichage de chaque symbole.

On observe, en figure 11, le récepteur 630, qui masque, dans cette coupe, l'émetteur 625 et le récepteur 635 et l'afficheur comportant des supports de symboles 640 et 645, le premier étant masqué, dans cette coupe, par le symbole 640. On a aussi représenté, en figure 11, les cônes d'émission 660 de l'émetteur 625 et du cône de réception 655 du récepteur 630, l'axe 665 du cône de réception 655 et un axe 670 perpendiculaire à un plan portant ledit symbole et prenant appui dans la zone convexe définie par ledit symbole. On rappelle ici qu'un convexe est, au sens mathématique, une surface ou un volume comportant tous les points qui se trouvent entre deux points d'une figure, ici un symbole. On observe que l'axe 670 perpendiculaire à un plan portant ledit symbole et prenant appui dans la zone convexe définie par ledit symbole intersecte l'axe de réception 665 du récepteur 630. Dans d'autres modes de réalisation, un axe perpendiculaire à un plan portant ledit symbole et prenant appui dans la zone convexe définie par ledit symbole intersecte l'axe d'émission d'un émetteur ou, à la fois, l'axe d'émission d'un émetteur et l'axe de réception d'un récepteur.

On observe, en figure 7, que dans le cinquième mode de réalisation du dispositif de commande objet de la présente invention, un écran 705 est disposé entre une pluralité d'émetteurs 710 et 715 et une pluralité de récepteurs 720 et 725. L'écran 705 est adapté à afficher des symboles 730, 735, 740 et 745, soit simultanément soit de manière intermittente, par exemple en fonctions de commandes possibles dans un état donné d'un dispositif électronique comportant le dispositif de commande illustré en figure 7.

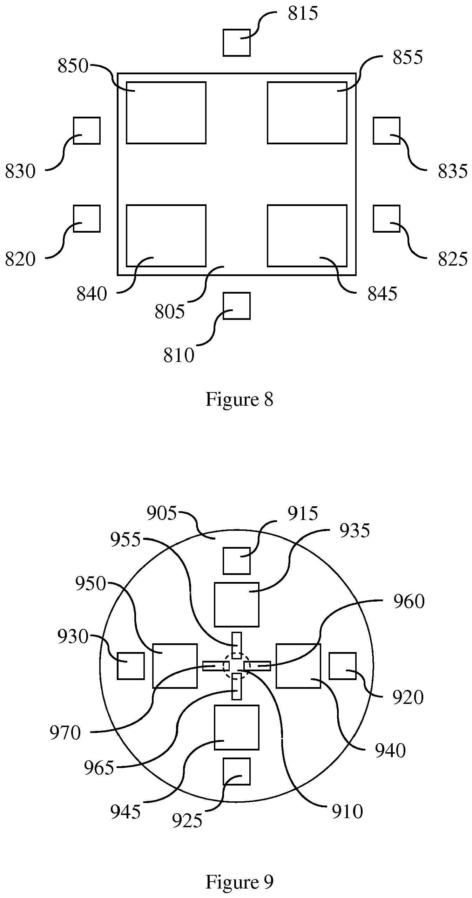

On observe, en figure 8, que dans le sixième mode de réalisation du dispositif de commande objet de la présente invention, un écran 805 est disposé entre une pluralité d'émetteurs 810 et 815 et une pluralité de récepteurs 820 à 835. L'écran 805 est adapté à afficher des symboles 840, 845, 850 et 855, soit simultanément soit de manière intermittente, par exemple en fonctions de commandes possibles dans un état donné d'un dispositif électronique comportant le dispositif de commande illustré en figure 8.

Dans des variantes, chaque zone de l'écran, 705 ou 805 ne peut afficher qu'un symbole. Dans d'autres variantes, l'écran, 705 ou 805, permet d'afficher différents symboles dans chaque zone de l'écran. En particulier, l'écran, 705 ou 805, est préférentiellement matriciel, ce qui permet d'afficher des symboles formés de dessins, d'icônes, de lettres, de nombres ou d'images, éventuellement animées, les styles et les polices utilisés pouvant varier d'un dispositif électronique à un autre ou, pour le même dispositif électronique, d'une configuration à une autre ou d'un pays à un autre.

D'une manière générale, dans des modes de réalisation, un écran est entouré d'au moins trois émetteurs et/ou récepteurs, les segments de droite reliant chaque émetteur à chaque récepteur chevauchant une zone de l'écran sur laquelle le moyen d'affichage est adapté à afficher un symbole.

La présente invention permet ainsi de constituer un écran tactile qui fonctionne sans contact entre le doigt de l'utilisateur et l'écran, ce qui présente les avantages indiqués en préambule, par rapport aux écrans tactiles traditionnels. On note qu'en utilisant des sources de lumière pulsées et des moyen de reconnaissance des pulsations émises, on peut constituer un écran tactile matriciel capable de discriminer un nombre de zones tactiles égal au produit du nombre d'émetteurs par le nombre de récepteurs, ces émetteurs et récepteurs étant positionnés autour de l'écran.

On observe, en figure 9, que dans un septième mode de réalisation 905 du dispositif de commande objet de la présente invention, un émetteur central 910 est entouré de symboles 940 à 955 situés entre cet émetteur central 910 et des récepteurs 915 à 930. Dans ce mode de réalisation, la surface du dispositif 905 est opaque pour les longueurs d'ondes utilisées, sauf en regard des récepteurs 915 à 930. Cependant, en regard de l'émetteur central 910, la surface du dispositif 905 est, au moins partiellement, transparente pour ces longueurs d'ondes, sur des zones 955 à 970 allongées vers les récepteurs, respectivement 915 à 930. Ainsi, la quantité de lumière émise par l'émetteur 910 est plus importante dans les directions des symboles 935 à 950 et des récepteurs 955 à 970 que dans les autres directions. Les zones 955 à 970 définissent ainsi des masques, dont la partie transparente, pour au moins une longueur d'onde utilisée par l'émetteur, est allongée dans la direction d'un récepteur capable de détecter la lumière à ladite longueur d'onde. Ces maques dont la partie transparente, pour au moins une longueur d'onde utilisée par l'émetteur, est allongé dans la direction d'un récepteur capable de détecter la lumière à ladite longueur d'onde. Ces masques peuvent être rectangulaires ou elliptiques, par exemple, leur plus grande dimension étant sensiblement parallèle à la droite reliant l'émetteur et le récepteur considéré. En variante, un tel masque est positionné en regard d'un récepteur, éventuellement en combinaison avec un tel masque positionné en regard d'un émetteur.

Pour chacun des modes de réalisation, la détection de la présence d'un doigt de l'utilisateur peut se faire en plusieurs étapes :
- détermination d'une moyenne de luminosité reçue par les récepteurs,
- détection si une, et une seule, des valeurs de lumière reçue dépasse cette moyenne et
- si oui, répétition de l'étape précédente, par exemple une milliseconde plus tard.

Si, de nouveau, c'est le même récepteur, et lui seul, qui reçoit plus que la moyenne mesurée, on considère que le symbole correspondant a été sélectionné par l'utilisateur. Sinon, on retourne à la première de ces étapes.

On note que la répétition de l'étape de détection permet de s'affranchir de phénomènes d'anti-rebonds.

Préférentiellement, comme exposé en regard de modes de réalisation détaillés ci-dessus, chaque émetteur et chaque récepteur de rayonnement se trouvent en dehors de la zone d'affichage de chaque symbole. La constitution du système est ainsi simplifiée et de moindre coût. En particulier, les émetteurs et récepteur ne se trouvent pas sous les symboles affichés, ce qui présente l'avantage indiqué ci-dessus. De plus, comme ni la lumière émise par l'émetteur, ni la lumière reçue par le récepteur ne traversant le symbole, la constitution de l'affichage de symbole, imprimé, actif ou passif, n'est en rien affectée par les caractéristiques techniques des émetteurs et récepteurs.

Les différents modes de réalisation exposés ci-dessus sont donnés à titre illustratif. D'autres modes de réalisation sont constitués en combinant les modes de réalisation exposés ci-dessus. Par exemple, le mode de réalisation illustré en figure 8, dans lequel les segments de droites reliant chaque émetteur à chaque récepteur chevauchent une zone de l'écran sur laquelle le moyen d'affichage est adapté à afficher un symbole se combine favorable au mode de réalisation illustré en figure 9, dans lequel au moins un émetteur de rayonnements est associé à au moins un masque dont la partie transparente, pour au moins une longueur d'onde utilisée par l'émetteur est allongé dans la direction d'un récepteur capable de détecter la lumière à ladite longueur d'onde.

La description des modes de réalisation du dispositif de commande et de ses fonctions définit un procédé de commande avec un dispositif comportant au moins un couple émetteur-récepteur, formé d'un émetteur de rayonnements et d'un récepteur de rayonnement émis par ledit émetteur et réfléchi par un corps mobile placé à distance du couple, dans le champ d'émission dudit émetteur, ledit récepteur étant disjoint dudit émetteur et adapté à fournir un signal électrique représentatif du rayonnement de l'émetteur qu'il reçoit,
couple dans lequel au moins un dit émetteur ou un dit récepteur de rayonnements est associé à au moins un masque dont la partie transparente, pour au moins une longueur d'onde utilisée par ledit émetteur, est allongée dans la direction d'un dit récepteur ou d'un dit émetteur, respectivement, capable de détecter la lumière à ladite longueur d'onde, caractérisé en ce qu'il comporte, en outre :
- une étape d'affichage, pour au moins un dit couple, d'au moins un symbole identifiant une action, face à une intersection du cône d'émission dudit émetteur et du cône de réception dudit récepteur, ledit émetteur et ledit récepteur étant ainsi en dehors de la zone d'affichage de chaque symbole et
- une étape de commande qui fournit des signaux de commande d'action en fonction du signal électrique fournis par au moins un dit récepteur, chaque couple d'émetteur-récepteur étant ainsi associé à au moins un symbole et au moins une action commandée lorsque le corps mobile se trouve devant le symbole identifiant ladite action.

## Revendications

1. Dispositif de commande, comportant au moins un couple émetteur-récepteur (125, 131, 134, 210, 216 à 219, 511, 513, 515, 625 à 635, 710 à 725, 810 à 835, 910 à 930), formé d'un émetteur de rayonnements et d'un récepteur de rayonnement émis par ledit émetteur et réfléchi par un corps mobile placé à distance du couple, dans le champ d'émission dudit émetteur, ledit récepteur étant disjoint dudit émetteur et adapté à fournir un signal électrique représentatif du rayonnement de l'émetteur qu'il reçoit, le dispositif de commande comportant, en outre :
- un moyen d'affichage (132, 133, 211 à 214, 640, 645, 705, 805, 935 à 950) adapté, pour au moins un dit couple, à afficher au moins un symbole identifiant une action, face à une intersection du cône d'émission dudit émetteur et du cône de réception dudit récepteur, ledit émetteur et ledit récepteur étant ainsi en dehors de la zone d'affichage de chaque symbole et
- un moyen de commande (110, 230, 315, 650) adapté à fournir des signaux de commande d'action en fonction du signal électrique fournis par au moins un dit récepteur, chaque couple d'émetteur-récepteur étant ainsi associé à au moins un symbole et au moins une action commandée lorsque le corps mobile se trouve devant le symbole identifiant ladite action,
dans lequel au moins un dit émetteur ou un dit récepteur de rayonnements est associé à au moins un masque (955 à 970) dont la partie transparente, pour au moins une longueur d'onde utilisée par l'émetteur, est allongée dans la direction d'un récepteur ou de l'émetteur, respectivement, capable de détecter la lumière à ladite longueur d'onde.

2. Dispositif de commande selon la revendication 1, **caractérisé en ce que** le moyen d'affichage est adapté à afficher au moins un symbole sur un écran (750, 805).

3. Dispositif de commande selon l'une des revendications 1 ou 2, caractérisé en que la zone d'affichage d'au moins un symbole (705, 805) est entourée d'au moins trois émetteurs et/ou récepteurs (710 à 725, 810 à 835), les segments de droites reliant chaque émetteur à chaque récepteur chevauchant une zone (730 à 745, 840 à 855) d'affichage d'un symbole.

4. Dispositif de commande selon l'une quelconque des revendications 1 à 3, **caractérisé en ce que** le moyen de commande comporte un moyen de traitement adapté à éliminer l'influence de la lumière ambiante non réfléchie par l'objet mobile réfléchissant.

5. Dispositif de commande selon l'une quelconque des revendications 1 à 4, **caractérisé en ce qu'**au moins un émetteur de rayonnements est adapté à émettre des rayonnements de manière intermittente et le moyen de traitement est adapté à mémoriser un niveau de signal électrique fourni par chaque récepteur lorsque l'émetteur de rayonnement n'émet pas de rayonnement, les signaux de commande d'action étant fonction du rayonnement instantané reçu et du niveau mémorisé.

6. Dispositif de commande selon l'une quelconque des revendications 1 à 5, **caractérisé en ce que** le moyen de commande est adapté à fournir un signal de sortie modulé en largeur d'impulsion.

7. Dispositif de commande selon l'une quelconque des revendications 1 à 6, **caractérisé en ce qu'**il comporte un moyen de communication pour recevoir ou transmettre des commandes à distance.

8. Dispositif de commande selon l'une quelconque des revendications 1 à 7, **caractérisé en ce que**, dans au moins un couple émetteur-récepteur, les axes d'émission de lumière par l'émetteur et de réception de lumière par le récepteur sont convergents.

9. Dispositif de commande selon l'une des revendications 1 à 8, dans lequel le moyen d'affichage (132, 133, 211 à 214, 640, 645, 705, 805, 935 à 950) est adapté, pour au moins un dit couple, à afficher au moins un symbole identifiant une action, un axe perpendiculaire à un plan portant ledit symbole et prenant appui dans la zone convexe, au sens mathématique, c'est-à-dire une surface ou un volume comportant tous les points qui se trouvent entre deux points d'une figure, définie par ledit symbole intersectant l'axe d'émission dudit émetteur et/ou l'axe de réception dudit récepteur.

10. Dispositif électronique (100) adapté à réaliser des actions, **caractérisé en ce qu'**il comporte un dispositif de commande selon l'une quelconque des revendications 1 à 9 qui commande au moins une dite action.

11. Procédé de commande avec un dispositif comportant au moins un couple émetteur-récepteur (125, 131, 134, 210, 216 à 219, 511, 513, 515, 625 à 635, 710 à 725, 810 à 835, 910 à 930), formé d'un émetteur de rayonnements et d'un récepteur de rayonnement émis par ledit émetteur et réfléchi par un corps mobile placé à distance du couple, dans le champ d'émission dudit émetteur, ledit récepteur étant disjoint dudit émetteur et adapté à fournir un signal électrique représentatif du rayonnement de l'émetteur qu'il reçoit,
couple dans lequel au moins un dit émetteur ou un dit récepteur de rayonnements est associé à au moins un masque (955 à 970) dont la partie transparente, pour au moins une longueur d'onde utilisée par ledit émetteur, est allongée dans la direction d'un dit récepteur ou d'un dit émetteur, respectivement, capable de détecter la lumière à ladite longueur d'onde, le procédé de commande comportant :
- une étape d'affichage, pour au moins un dit couple, d'au moins un symbole identifiant une action, face à une intersection du cône d'émission dudit émetteur et du cône de réception dudit récepteur, ledit émetteur et ledit récepteur étant ainsi en dehors de la zone d'affichage de chaque symbole et
- une étape de commande (110, 230, 315, 650) qui fournit des signaux de commande d'action en fonction du signal électrique fournis par au moins un dit récepteur, chaque couple d'émetteur-récepteur étant ainsi associé à au moins un symbole et au moins une action commandée lorsque le corps mobile se trouve devant le symbole identifiant ladite action.

## Patentansprüche

1. Steuereinrichtung, zumindest ein Sender-Empfänger-Paar (125, 131, 134, 210, 216 bis 219, 511, 513, 515, 625 bis 635, 710 bis 725, 810 bis 835, 910 bis 930) umfassend, gebildet durch einen Sender von Strahlungen und einen Empfänger einer Strahlung, die durch den besagten Sender gesendet, und durch einen beweglichen Körper, der auf Abstand zum Paar platziert ist, reflektiert wird, wobei der besagte Empfänger im Sendefeld des besagten Senders vom besagten Sender getrennt ist, und ausgeführt ist, um ein elektrisches Signal bereitzustellen, das repräsentativ für die Strahlung des Senders ist, die er empfängt, wobei die Steuereinrichtung darüber hinaus umfasst:
- ein Anzeigemittel (132, 133, 211 bis 214, 640, 645, 705, 805, 935 bis 950), ausgeführt, um für zumindest ein besagtes Paar zumindest ein Symbol anzuzeigen, das eine Aktion identifiziert, gegenüber einem Schnittpunkt des Sendekonus des besagten Senders und des Empfangskonus des besagten Empfängers, wobei der besagte Sender und der besagte Empfänger somit außerhalb der Anzeigezone eines jeden Symbols sind, und
- ein Steuermittel (110, 230, 315, 650), ausgeführt, um Aktionssteuersignale in Abhängigkeit vom elektrischen Signal bereitzustellen, das durch zumindest einen besagten Empfänger bereitgestellt wird, wobei jedes Sender-Empfänger-Paar somit zumindest einem Symbol und zumindest einer Aktion zugeordnet ist, die angesteuert wird, wenn sich der bewegliche Körper vor dem Symbol befindet, welches die besagte Aktion identifiziert,
wobei zumindest ein besagter Sender oder ein besagter Empfänger von Strahlungen zumindest einer Maske (955 bis 970) zugeordnet ist, deren transparenter Abschnitt für zumindest eine Wellenlänge, die vom Sender verwendet wird, in die Richtung eines Empfängers oder des Senders verlängert wird, der jeweils in der Lage ist, das Licht mit der besagten Wellenlänge zu erfassen.

2. Steuereinrichtung nach Anspruch 1, **dadurch gekennzeichnet, dass** das Anzeigemittel ausgeführt ist, um zumindest ein Symbol auf einem Bildschirm (750, 805) anzuzeigen.

3. Steuereinrichtung nach einem der Ansprüche 1 oder 2, **dadurch gekennzeichnet, dass** die Zone zur Anzeige zumindest eines Symbols (705, 805) von zumindest drei Sendern und/ oder Empfängern (710 bis 725, 810 bis 835) umgeben ist, wobei die Liniensegmente, die jeden Sender mit jedem Empfänger verbinden, eine Zone (730 bis 745, 840 bis 855) zur Anzeige eines Symbols überschneiden.

4. Steuereinrichtung nach einem der Ansprüche 1 bis 3, **dadurch gekennzeichnet, dass** das Steuermittel ein Bearbeitungsmittel umfasst, das ausgeführt ist, um den Einfluss des Umgebungslichts zu eliminieren, das vom reflektierenden beweglichen Gegenstand nicht reflektiert wird.

5. Steuereinrichtung nach einem der Ansprüche 1 bis 4, **dadurch gekennzeichnet, dass** zumindest ein Sender von Strahlungen ausgeführt ist, um Strahlungen intervallweise zu senden und das Bearbeitungsmittel ausgeführt ist, um ein elektrisches Signalniveau zu speichern, das durch jeden Empfänger bereitgestellt wird, wenn der Sender von Strahlung keine Strahlung sendet, wobei die Aktionssteuersignale von der empfangenen momentanen Strahlung und dem gespeicherten Niveau abhängen.

6. Steuereinrichtung nach einem der Ansprüche 1 bis 5, **dadurch gekennzeichnet, dass** das Steuermittel ausgeführt ist, um ein in der Impulsbreite moduliertes Ausgangssignal bereitzustellen.

7. Steuereinrichtung nach einem der Ansprüche 1 bis 6, **dadurch gekennzeichnet, dass** sie ein Kommunikationsmittel umfasst, um Fernsteuerungen zu empfangen oder zu übertragen.

8. Steuereinrichtung nach einem der Ansprüche 1 bis 7, **dadurch gekennzeichnet, dass** in zumindest einem Sender-Empfänger-Paar die Lichtsenderachsen durch den Sender und Lichtmpfängerachsen durch den Empfänger zusammenlaufend sind.

9. Steuereinrichtung nach einem der Ansprüche 1 bis 8, wobei das Anzeigemittel (132, 133, 211 bis 214, 640, 645, 705, 805, 935 bis 950) für zumindest ein besagtes Paar ausgeführt ist, um zumindest ein Symbol anzuzeigen, das eine Aktion identifiziert, wobei eine Achse senkrecht zu einer Ebene, die das besagte Symbol trägt, und sich im mathematischen Sinne in der konvexen Zone anlegt, das heißt eine Fläche oder ein Volumen, alle Punkte umfassend, die sich zwischen zwei Punkten einer Figur befinden, die durch das besagte Symbol definiert wird, die Sendeachse des besagten Senders und/ oder die Empfangsachse des besagten Empfängers schneidet.

10. Elektronische Einrichtung (100), ausgeführt, um Aktionen durchzuführen, **dadurch gekennzeichnet, dass** sie eine Steuereinrichtung nach einem der Ansprüche 1 bis 9 umfasst, die zumindest eine besagte Aktion steuert.

11. Steuerverfahren mit einer Vorrichtung, zumindest ein Sender-Empfänger-Paar (125, 131, 134, 210, 216 bis 219, 511, 513, 515, 625 bis 635, 710 bis 725, 810 bis 835, 910 bis 930) umfassend, gebildet durch einen Sender von Strahlungen und einen Empfänger von Strahlung, die durch den besagten Sender gesendet, und durch einen beweglichen Körper reflektiert wird, der auf Abstand zum Paar platziert ist, wobei der besagte Empfänger im Sendefeld des besagten Senders vom besagten Sender getrennt ist, und ausgeführt ist, um ein elektrisches Signal bereitzustellen, das für die Strahlung des Senders repräsentativ ist, die er empfängt,
Paar, bei dem zumindest ein besagter Sender oder ein besagter Empfänger von Strahlungen zumindest einer Maske (955 bis 970) zugeordnet ist, deren transparenter Abschnitt für zumindest eine Wellenlänge, die vom Sender verwendet wird, in die Richtung eines Empfängers oder des Senders verlängert wird, der jeweils in der Lage ist, das Licht mit der besagten Wellenlänge zu erfassen, wobei das Steuerverfahren umfasst
- einen Schritt zur Anzeige, für zumindest ein besagtes Paar, zumindest eines Symbols, das eine Aktion identifiziert, gegenüber einem Schnittpunkt des Sendekonus des besagten Senders und des Empfangskonus des besagten Empfängers, wobei der besagte Sender und der besagte Empfänger somit außerhalb der Anzeigezone eines jeden Symbols sind, und
- einen Steuerschritt (110, 230, 315, 650), der Aktionssteuersignale in Abhängigkeit vom elektrischen Signal bereitstellt, das durch zumindest einen besagten Empfänger bereitgestellt wird, wobei jedes Sender-Empfänger-Paar somit zumindest einem Symbol und zumindest einer Aktion zugeordnet ist, die angesteuert wird, wenn sich der bewegliche Körper vor dem Symbol befindet, welches die besagte Aktion identifiziert.

## Claims

1. Control device comprising at least one emitter-receiver pair (125, 131, 134, 210, 216 to 219, 511, 513, 515, 625 to 635, 710 to 725, 810 to 835, 910 to 930), made up of a radiation emitter and a receiver for the radiation emitted by said emitter and reflected by a moving body located at a distance from the pair, within the emission field of said emitter, said receiver being separate from said emitter and designed to provide an electrical signal representative of the radiation received from the emitter, the control device also comprising:
- display means (132, 133, 211 to 214, 640, 645, 705, 805, 935 to 950) designed, for at least one said pair, to display at least one symbol that identifies an action, opposite an intersection of said emitter's emission cone with the reception cone of said receiver, said emitter and said receiver being thus outside the display area of each symbol and
- control means (110, 230, 315, 650) designed to provide action instruction signals as a function of the electrical signal provided by at least one said receiver, each emitter-receiver pair thus being associated with at least one symbol and at least one action instruction when the moving body is in front of the symbol that identifies said action,
wherein at least one said emitter or said receiver of radiation is associated with at least one mask (955 to 970), whose transparent portion, for at least one wavelength used by the emitter, is elongated in the direction of a receiver or the emitter, respectively, able to detect light of said wavelength.

2. Control device according to claim 1, **characterized in that** the display means is designed to display at least one symbol on a screen (750, 805).

3. Control device according to one of claims 1 or 2, **characterized in that** the display area of at least one symbol (705, 805) is surrounded by at least three emitters and/or receivers (710 to 725, 810 to 835), the segments of lines connecting each emitter to each receiver overlapping an area (730 to 745, 840 to 855) for displaying a symbol.

4. Control device according to any one of claims 1 to 3, **characterized in that** the control means comprises processing means designed to eliminate the impact of the ambient light not reflected by the reflecting moving object.

5. Control device according to any one of claims 1 to 4, **characterized in that** at least one radiation emitter is designed to emit radiation in an intermittent manner and the processing means is designed to store an electrical signal level sent by each receiver when the radiation emitter is not emitting any radiation, the action instruction signals being a function of the instantaneous radiation received and of the stored level.

6. Control device according to any one of claims 1 to 5, **characterized in that** the control means is designed to provide an output signal modulated according to the magnitude of the stimulus.

7. Control device according to any one of claims 1 to 6, **characterized in that** it comprises communication means for receiving or transmitting instructions remotely.

8. Control device according to any one of claims 1 to 7, **characterized in that**, in at least one emitter-receiver pair, the light emission axis of the emitter and the light reception axis of the receiver are convergent.

9. Control device according to any one of claims 1 to 8, wherein the display means (132, 133, 211 to 214, 640, 645, 705, 805, 935 to 950) is designed, for at least one said pair, to display at least one symbol that identifies an action, an axis perpendicular to a plane bearing said symbol and resting within the convex area, in the mathematical sense, ie a surface or a volume that comprises all the points located between two points of a figure, is defined by the intersection of said symbol with the emission axis of said emitter and/or the reception axis of said receiver.

10. Electronic device (100) designed to realize actions, **characterized in that** it comprises a control device according to any one of claims 1 to 9, which controls at least one said action.

11. Control method with a device comprising at least one emitter-receiver pair (125, 131, 134, 210, 216 to 219, 511, 513, 515, 625 to 635, 710 to 725, 810 to 835, 910 to 930), made up of a radiation emitter and a receiver for the radiation emitted by said emitter and reflected by a moving body located at a distance from the pair, within the emission field of said emitter, said receiver being separate from said emitter and designed to provide an electrical signal representative of the radiation received from the emitter, in which pair at least one said emitter or said receiver of radiation is associated with at least one mask (955 to 970), whose transparent portion, for at least one wavelength used by said emitter, is elongated in the direction of a said receiver or a said emitter, respectively, able to detect light of said wavelength, the control method comprising:
- a step of displaying, for at least one said pair, at least one symbol identifying an action, opposite an intersection of the emission cone of said emitter with the reception cone of said receiver, said emitter and said receiver being thus outside the display area of each symbol and
- a control step (110, 230, 315, 650) that provides action instruction signals as a function of the electrical signal provided by at least one said receiver, each emitter-receiver pair thus being associated with at least one symbol and at least one action instruction when the moving body is in front of the symbol that identifies said action.
